# EUROPEAN PATENT SPECIFICATION

(11) **EP 3 872 505 B1**
(45) Date of publication and mention of the grant of the patent: **26.10.2022**
(21) Application number: 20817180.1
(22) Date of filing: 22.05.2020
(51) Int. Cl.: G01R 31/00, G01R 31/40

(54) **CHARGING PILE TEST METHOD, DEVICE AND SYSTEM, STORAGE MEDIUM AND PROCESSOR**
VERFAHREN, VORRICHTUNG UND SYSTEM ZUR LADESTAPELPRÜFUNG, SPEICHERMEDIUM UND PROZESSOR
PROCÉDÉ, DISPOSITIF ET SYSTÈME DE TEST DE PILES DE CHARGE, SUPPORT D'INFORMATIONS ET PROCESSEUR

(30) Priority: 31.12.2019 CN 201911425459
(43) Date of publication of application: 01.09.2021
(73) Proprietor: State Grid Beijing Electric Power Company, Beijing 100031 (CN); State Grid Corporation of China (SGCC), Beijing 100031 (CN)
(72) Inventor: LIU, Xiulan, Beijing 100031 (CN) (CN); JIN, Yuan, Beijing 100031 (CN) (CN); CHEN, Ping, Beijing 100031 (CN) (CN); JI, Hongquan, Beijing 100031 (CN) (CN); LI, Xianglong, Beijing 100031 (CN) (CN); ZHU, Jie, Beijing 100031 (CN) (CN); ZHANG, Baoqun, Beijing 100031 (CN) (CN); QIU, Mingquan, Beijing 100031 (CN) (CN); CHEN, Xi, Beijing 100031 (CN) (CN); LI, Haitao, Beijing 100031 (CN) (CN); ZHAO, Yutong, Beijing 100031 (CN) (CN); CHEN, Haiyang, Beijing 100031 (CN) (CN); CHENG, Lin, Beijing 100031 (CN) (CN); ZHANG, Qian, Beijing 100031 (CN) (CN); GUAN, Yu, Beijing 100031 (CN) (CN); LIN, Zhifa, Beijing 100031 (CN) (CN)
(74) Representative: Meyer, Thorsten
(86) International application number: PCT/CN2020/091704
(87) International publication number: WO 2021/135050

(56) References cited:
- CN-A- 102 680 911
- CN-A- 107 064 701
- CN-A- 108 152 644
- CN-A- 109 342 971
- CN-A- 109 709 418
- CN-A- 111 157 820
- CN-U- 209 858 649
- CN-U- 209 858 649
- US-A1- 2013 346 025
- US-A1- 2017 036 558

## Description

### TECHNICAL FIELD

The present invention relates to the field of charging pile testing, and in particular, to a testing method, apparatus and system for a charging pile, a storage medium, and a processor.

### BACKGROUND

According to test requirements of a charging pile assembly line, all charging piles need to be tested at a full power. If all the charging piles are tested simultaneously, the total incoming power will be extremely high. The number of power supplies and the number of loads both need to be the same as the number of the charging piles under test. Reference document CN 109342971A discloses a quality inspection system for charging pile components and an AC/DC charging pile component inspection system, in which the components of AC and DC charging piles are inspected and the energy from the inspection process can be recovered to avoid wasting energy. Reference document CN 209858649U discloses an electric vehicle charging equipment testing device with scaled modular design for each component, capable of testing both DC and AC charging piles. Reference document US 2013/346025 A1 discloses a method of testing an electric vehicle (EV) charging apparatus using an EV charging tester, the method comprising: receiving an indication of a charging protocol used by an EV charging apparatus; providing a simulation signal to the EV charging apparatus, the signal simulating an EV acting in compliance with the charging protocol; and receiving a charge load from the EV charging apparatus with a load module. Reference document CN 107064701A discloses a charging pile experimental device and system for full-load performance testing of charging piles, realizing the reuse of the output electrical energy of the charging piles, and effectively alleviating the large waste of electrical energy generated during full-load performance testing of charging piles.

At present, a plurality of charging piles are tested in a parallel way manually, and the charging piles do not coordinate with each other. To meet the test requirements, one method is to configure the number of power supplies and the number of loads according to the number of stations under test. This method increases the number of devices, investment, and occupation of land. Another method is to wait until the power supply and the load become idle without increasing the number of devices, which results in low detection efficiency.

Currently, there is no effective solution to solve the foregoing problem of low efficiency of batch testing for charging piles.

### SUMMARY

Embodiments of the present invention provide a testing method, apparatus and system for a charging pile, a storage medium, and a processor, to at least solve the technical problem of low efficiency of batch testing for charging piles.

According to one aspect of the embodiments of the present invention, a testing method for a charging pile is provided, including: obtaining a test task set of a charging pile, where the test task set includes at least a first test task and a second test task, the first test task is used for instructing the charging pile to perform a test based on conditions of a first power supply and a first load, and the second test task is used for instructing the charging pile to perform a test based on conditions of a second power supply and a second load; configuring the first power supply and the first load for a first charging pile in at least one to-be-tested charging pile and controlling the first charging pile to execute the first test task, and configuring the second power supply and the second load for a second charging pile in the at least one to-be-tested charging pile and controlling the second charging pile to execute the second test task; and after the first charging pile completes the first test task and the second charging pile completes the second test task, configuring the second power supply and the second load for the first charging pile and controlling the first charging pile to execute the second test task, and configuring the first power supply and the first load for the second charging pile and controlling the second charging pile to execute the first test task; and monitoring all test tasks executed by a plurality of charging piles in the same period of time, and determining whether a total power supply power and a total load power required by all the test tasks in the same period of time exceed a total power supply power and a total load power that can be provided in a current environment; if in the same period of time, the first charging pile and the second charging pile execute the first test task simultaneously, and a total power supply power and a total load power required for executing the first test task by the first charging pile and the second charging pile simultaneously exceed the total power supply power and the total load power that can be provided in the current environment, selecting the second test task that requires a relatively low power supply power and load power from the test task set, and controlling the second charging pile executes the second test task while the first charging pile executes the first test task.

Optionally, the configuring the first power supply for the first charging pile and configuring the second power supply for the second charging pile includes: controlling a main power supply to supply power to the first charging pile according to a power of the first power supply; and controlling the main power supply to supply power to the second charging pile according to a power of the second power supply.

Optionally, the configuring the first load for the first charging pile and configuring the second load for the second charging pile includes: selecting, according to a power of the first load, at least one load module from a predetermined load set and connecting the at least one load module in series to the first charging pile; and selecting, according to a power of the second load, at least one load module from the predetermined load set and connecting the at least one load module in series to the second charging pile; where the predetermined load set includes a plurality of load modules, and the plurality of load modules are connected through a switch array.

According to another aspect of the embodiments of the present invention, a testing apparatus for a charging pile is further provided, including: an obtaining unit, configured to obtain a test task set of a charging pile, where the test task set includes at least a first test task and a second test task, the first test task is used for instructing the charging pile to perform a test based on conditions of a first power supply and a first load, and the second test task is used for instructing the charging pile to perform a test based on conditions of a second power supply and a second load; a first test unit, configured to configure the first power supply and the first load for a first charging pile in at least one to-be-tested charging pile and control the first charging pile to execute the first test task, and configure the second power supply and the second load for a second charging pile in the at least one to-be-tested charging pile and control the second charging pile to execute the second test task; and a second test unit, configured to: after the first charging pile completes the first test task and the second charging pile completes the second test task, configure the second power supply and the second load for the first charging pile and control the first charging pile to execute the second test task, and configure the first power supply and the first load for the second charging pile and control the second charging pile to execute the first test task; and the apparatus is further configured to: monitor all test tasks executed by a plurality of charging piles in the same period of time, and determine whether a total power supply power and a total load power required by all the test tasks in the same period of time exceed a total power supply power and a total load power that can be provided in a current environment; if in the same period of time, the first charging pile and the second charging pile execute the first test task simultaneously, and a total power supply power and a total load power required for executing the first test task by the first charging pile and the second charging pile simultaneously exceed the total power supply power and the total load power that can be provided in the current environment, select the second test task that requires a relatively low power supply power and load power from the test task set, and control the second charging pile executes the second test task while the first charging pile executes the first test task.

Optionally, the apparatus further includes: a power supply control unit, where the power supply control unit includes at least a first power supply control module and a second power supply control module, the first power supply control module is configured to control a main power supply to supply power to the first charging pile according to a power of the first power supply; and the second power supply control module is configured to control the main power supply to supply power to the second charging pile according to a power of the second power supply.

Optionally, the apparatus further includes: a load control unit, where the load control unit includes at least a first load control module and a second load control module, the first load control module is configured to select, according to a power of the first load, at least one load module from a predetermined load set and connect the at least one load module in series to the first charging pile; and the second load control module is configured to select, according to a power of the second load, at least one load module from the predetermined load set and connect the at least one load module in series to the second charging pile; where the predetermined load set includes a plurality of load modules, and the plurality of load modules are connected through a switch array.

According to still another aspect of the embodiments of the present invention, a testing system for a charging pile is further provided, including: at least one to-be-tested charging pile, where the at least one to-be-tested charging pile includes at least a first charging pile and a second charging pile; a predetermined load set, configured to provide loads for the at least one to-be-tested charging pile, where the predetermined load set includes plurality of load modules; a main power supply, configured to supply power to the at least one to-be-tested charging pile; and
a controller, connected to the at least one to-be-tested charging pile, the predetermined load set and the main power supply, and wherein comprises an obtaining unit (22), a first test unit (24) and a second test unit (26); and the controller is configured to monitor all test tasks executed by a plurality of charging piles in the same period of time, and determining whether a total power supply power and a total load power required by all the test tasks in the same period of time exceed a total power supply power and a total load power that can be provided in a current environment; if in the same period of time, the first charging pile and the second charging pile execute the first test task simultaneously, and a total power supply power and a total load power required for executing the first test task by the first charging pile and the second charging pile simultaneously exceed the total power supply power and the total load power that can be provided in the current environment, select the second test task that requires a relatively low power supply power and load power from the test task set, and control the second charging pile executes the second test task while the first charging pile executes the first test task; where the first power supply and the second power supply are configured based on the main power supply, and a sum of a power of the first power supply and a power of the second power supply is not higher than a total power of the main power supply; the first load and the second load are configured based on the predetermined load set, and a sum of a power of the first load and a power of the second load is not higher than a total power of the plurality of load modules in the predetermined load set.

Optionally, the plurality of load modules in the predetermined load set are connected through a switch array.

According to yet another aspect of the embodiments of the present invention, a storage medium is provided, including a stored program, where the program, when being run, controls a device where the storage medium is located to perform the above testing method for a charging pile.

According to still yet another aspect of the embodiments of the present invention, a processor is provided, configured to run a program, where the program, when being run, performs the above testing method for a charging pile.

In the embodiments of the present invention, a test task set of a charging pile is obtained, where the test task set includes: a first test task and a second test task; a first power supply and a first load required for executing the first test task by the charging pile are configured based on the first test task; a second power supply and a second load required for executing the second test task by the charging pile are configured based on the second test task; a first charging pile is controlled to execute to the first test task based on the first power supply and the first load, and a second charging pile is controlled to execute the second test task based on the second power supply and the second load; after the first charging pile completes the first test task and the second charging pile completes the second test task, the first charging pile is controlled to execute the second test task based on the second power supply and the second load, and the second charging pile is controlled to execute the first test task based on the first power supply and the first load, so that the first charging pile and the second charging pile can execute test tasks in a time division manner. That is, the second charging pile executes the second test task while the first charging pile executes the first test task, and after the first charging pile completes the first test task and the second charging pile also completes the second test task, the first test task and the second test task are exchanged, so that the first charging pile and the second charging pile can execute the same test task in different periods of time. Test tasks with relatively high powers and relatively high loads are arranged in the same period of time, so that a total power supply power required for the test and a total load power required for the test can be reduced when a plurality of charging piles are tested simultaneously. Therefore, with the limited total power supply power and the limited total load power, a plurality of charging piles can be tested simultaneously, thereby achieving the technical effect of improving the efficiency of batch testing for charging piles, and solving the technical problem of low efficiency of batch testing for charging piles.

### BRIEF DESCRIPTION OF THE DRAWINGS

The accompanying drawings described here are provided for further understanding of the present invention, and constitute a part of this application. The exemplary embodiments of the present invention and illustrations thereof are intended to explain the present invention, but do not constitute inappropriate limitations to the present invention. In the accompanying drawings:
FIG. 1 is a flowchart of a testing method for a charging pile according to an embodiment of the present invention;
FIG. 2 is a schematic diagram of a testing apparatus for a charging pile according to an embodiment of the present invention;
FIG. 3 is a schematic diagram of a testing apparatus for a charging pile according to an embodiment of the present invention;
FIG. 4 is a schematic diagram of an assembly line testing system for charging piles according to an embodiment of the present invention;
FIG. 5 is a schematic diagram of an assembly line test control part for charging piles according to an embodiment of the present invention; and
FIG. 6 is a schematic diagram of a test process of an assembly line for charging piles according to an embodiment of the present invention.

### DETAILED DESCRIPTION

To make persons skilled in the art better understand the present invention, the following clearly and completely describes the technical solutions in the embodiments of the present invention with reference to the accompanying drawings in the embodiments of the present invention. Apparently, the described embodiments are merely some rather than all of the embodiments of the present invention. All other embodiments obtained by persons of ordinary skill in the art based on the embodiments of the present invention without creative efforts shall fall within the scope of protection of the present invention.

It should be noted that the terms "first", "second", and so on in the specification and claims of the present invention and in the accompanying drawings are intended to distinguish between similar objects but do not necessarily indicate a specific order or sequence. It should be understood that the objects used in such a way may be exchanged under proper conditions to make it possible to implement the described embodiments of the present invention in other sequences apart from those illustrated or described here. Moreover, the terms "include", "contain", and any other variants mean to cover the non-exclusive inclusion, for example, a process, method, system, product, or device that includes a list of steps or units is not necessarily limited to those steps or units which are clearly listed, but may include other steps or units which are not expressly listed or inherent to such a process, method, system, product, or device.

According to the embodiments of the present invention, an embodiment of a testing method for a charging pile is provided. It should be noted that, steps shown in the flowchart in the accompanying drawings may be executed in a computer system such as a set of computer executable instructions. Moreover, although a logic sequence is shown in the flowchart, the shown or described steps may be executed in a sequence different from that described here.

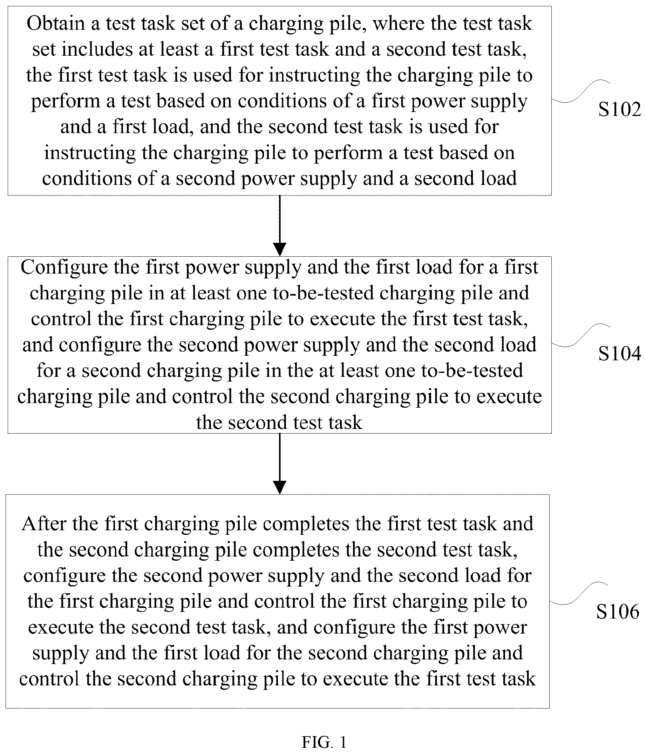

FIG. 1 is a flowchart of a testing method for a charging pile according to an embodiment of the present invention. As shown in FIG. 1, the method includes the following steps:
Step S102: obtain a test task set of a charging pile, where the test task set includes at least a first test task and a second test task, the first test task is used for instructing the charging pile to perform a test based on conditions of a first power supply and a first load, and the second test task is used for instructing the charging pile to perform a test based on conditions of a second power supply and a second load.
Step S104: configure the first power supply and the first load for a first charging pile in at least one to-be-tested charging pile and control the first charging pile to execute the first test task, and configure the second power supply and the second load for a second charging pile in the at least one to-be-tested charging pile and control the second charging pile to execute the second test task.
Step S106: after the first charging pile completes the first test task and the second charging pile completes the second test task, configure the second power supply and the second load for the first charging pile and control the first charging pile to execute the second test task, and configure the first power supply and the first load for the second charging pile and control the second charging pile to execute the first test task.

In the embodiments of the present invention, a test task set of a charging pile is obtained, where the test task set includes: a first test task and a second test task; a first power supply and a first load required for executing the first test task by the charging pile are configured based on the first test task; a second power supply and a second load required for executing the second test task by the charging pile are configured based on the second test task; a first charging pile is controlled to execute to the first test task based on the first power supply and the first load, and a second charging pile is controlled to execute the second test task based on the second power supply and the second load; after the first charging pile completes the first test task and the second charging pile completes the second test task, the first charging pile is controlled to execute the second test task based on the second power supply and the second load, and the second charging pile is controlled to execute the first test task based on the first power supply and the first load, so that the first charging pile and the second charging pile can execute test tasks in a time division manner. That is, the second charging pile executes the second test task while the first charging pile executes the first test task, and after the first charging pile completes the first test task and the second charging pile also completes the second test task, the first test task and the second test task are exchanged, so that the first charging pile and the second charging pile can execute the same test task in different periods of time. Test tasks with relatively high powers and relatively high loads are arranged in the same period of time, so that a total power supply power required for the test and a total load power required for the test can be reduced when a plurality of charging piles are tested simultaneously. Therefore, with the limited total power supply power and the limited total load power, a plurality of charging piles can be tested simultaneously, thereby achieving the technical effect of improving the efficiency of batch testing for charging piles, and solving the technical problem of low efficiency of batch testing for charging piles.

Optionally, a power of the first power supply is different from a power of the second power supply, and a power of the first load is different from a power of the second load.

Optionally, the test task set includes a plurality of test tasks, and the plurality of test tasks are arranged in order. The arrangement order of the test tasks may indicate an order in which the test tasks are executed by the charging pile.

For example, if an arrangement order of test tasks in the test task set is test task A and test task B, the charging pile may execute the test task A first, and then execute the test task B.

The method further includes: monitoring all test tasks executed by a plurality of charging piles in the same period of time, and determining whether a total power supply power and a total load power required by all the test tasks in the same period of time exceed a total power supply power and a total load power that can be provided in a current environment; if the total power supply power and the total load power required by all the test tasks in the same period of time exceed the total power supply power and the total load power that can be provided in the current environment, adjusting the test tasks in the same period of time, to combine a test task that requires a relatively high power supply power and load power with a test task that requires a relatively low power supply power and load power.

For example, in the same period of time, the first charging pile and the second charging pile execute the first test task simultaneously, and a total power supply power and a total load power required for executing the first test task by the first charging pile and the second charging pile simultaneously exceed the total power supply power and the total load power that can be provided in the current environment. In this case, the second test task that requires a relatively low power supply power and load power may be selected from the test task set, and while the first charging pile executes the first test task, the second charging pile executes the second test task.

The configuring the first power supply for the first charging pile and configuring the second power supply for the second charging pile includes: controlling a main power supply to supply power to the first charging pile according to a power of the first power supply; and controlling the main power supply to supply power to the second charging pile according to a power of the second power supply.

Optionally, the main power supply is a programmable power supply, which can supply power to a plurality of devices (or charging piles) according to different powers.

In an optional embodiment, the configuring the first load for the first charging pile and configuring the second load for the second charging pile includes: selecting, according to a power of the first load, at least one load module from a predetermined load set and connecting the at least one load module in series to the first charging pile; selecting, according to a power of the second load, at least one load module from the predetermined load set and connecting the at least one load module in series to the second charging pile, where the predetermined load set includes a plurality of load modules, and the plurality of load modules are connected through a switch array.

According to another embodiment of the present invention, a storage medium is further provided. The storage medium includes a stored program, where the program, when being run, executes the testing method for a charging pile described above.

According to another embodiment of the present invention, a processor is further provided. The processor is configured to run a program, where the program, when being run, executes the testing method for a charging pile described above.

According to the embodiments of the present invention, an embodiment of a testing apparatus for a charging pile is further provided. It should be noted that, the testing apparatus for a charging pile may be configured to perform the testing method for a charging pile in the embodiments of the present invention, and the testing method for a charging pile in the embodiments of the present invention may be performed in the testing apparatus for a charging pile.

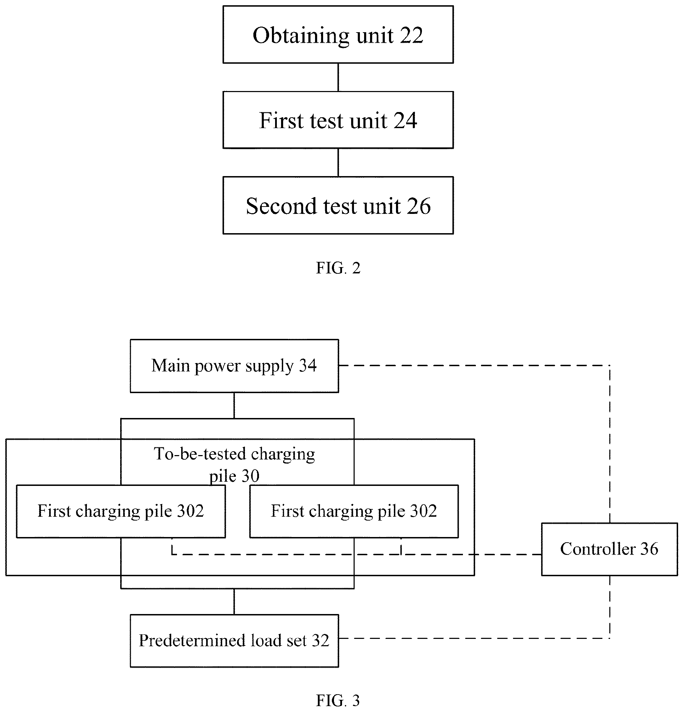

FIG. 2 is a schematic diagram of a testing apparatus for a charging pile according to an embodiment of the present invention. As shown in FIG. 2, the apparatus may include: an obtaining unit 22, configured to obtain a test task set of a charging pile, where the test task set includes at least a first test task and a second test task, the first test task is used for instructing the charging pile to perform a test based on conditions of a first power supply and a first load, and the second test task is used for instructing the charging pile to perform a test based on conditions of a second power supply and a second load; a first test unit 24, configured to configure the first power supply and the first load for a first charging pile in at least one to-be-tested charging pile and control the first charging pile to execute the first test task, and configure the second power supply and the second load for a second charging pile in the at least one to-be-tested charging pile and control the second charging pile to execute the second test task; and a second test unit 26, configured to: after the first charging pile completes the first test task and the second charging pile completes the second test task, configure the second power supply and the second load for the first charging pile and control the first charging pile to execute the second test task, and configure the first power supply and the first load for the second charging pile and control the second charging pile to execute the first test task.

It should be noted that, the obtaining unit 22 in this embodiment may be configured to perform step S102 in the embodiment of this application, the first test unit 24 in this embodiment may be configured to perform step S104 in the embodiment of this application, and the second test unit 26 in this embodiment may be configured to perform step S106 in the embodiment of this application. The foregoing units and the corresponding steps implement the same example and have the same application scenario, which are not limited to the content disclosed in the foregoing embodiment.

In the embodiments of the present invention, a test task set of a charging pile is obtained, where the test task set includes: a first test task and a second test task; a first power supply and a first load required for executing the first test task by the charging pile are configured based on the first test task; a second power supply and a second load required for executing the second test task by the charging pile are configured based on the second test task; a first charging pile is controlled to execute to the first test task based on the first power supply and the first load, and a second charging pile is controlled to execute the second test task based on the second power supply and the second load; after the first charging pile completes the first test task and the second charging pile completes the second test task, the first charging pile is controlled to execute the second test task based on the second power supply and the second load, and the second charging pile is controlled to execute the first test task based on the first power supply and the first load, so that the first charging pile and the second charging pile can execute test tasks in a time division manner. That is, the second charging pile executes the second test task while the first charging pile executes the first test task, and after the first charging pile completes the first test task and the second charging pile also completes the second test task, the first test task and the second test task are exchanged, so that the first charging pile and the second charging pile can execute the same test task in different periods of time. Test tasks with relatively high powers and relatively high loads are arranged in the same period of time, so that a total power supply power required for the test and a total load power required for the test can be reduced when a plurality of charging piles are tested simultaneously. Therefore, with the limited total power supply power and the limited total load power, a plurality of charging piles can be tested simultaneously, thereby achieving the technical effect of improving the efficiency of batch testing for charging piles, and solving the technical problem of low efficiency of batch testing for charging piles.

In an optional embodiment, the apparatus further includes a power supply control unit, where the power supply control unit includes at least a first power supply control module and a second power supply control module; the first power supply control module is configured to control a main power supply to supply power to the first charging pile according to a power of the first power supply; the second power supply control module is configured to control the main power supply to supply power to the second charging pile according to a power of the second power supply.

In an optional embodiment, the apparatus further includes a load control unit, where the load control unit includes at least a first load control module and a second load control module; the first load control module is configured to select, according to a power of the first load, at least one load module from a predetermined load set and connect the at least one load module in series to the first charging pile; and the second load control module is configured to select, according to a power of the second load, at least one load module from the predetermined load set and connect the at least one load module in series to the second charging pile, where the predetermined load set includes a plurality of load modules, and the plurality of load modules are connected through a switch array.

FIG. 3 is a schematic diagram of a testing apparatus for a charging pile according to an embodiment of the present invention. As shown in FIG. 3, the apparatus includes: at least one to-be-tested charging pile 30, where the at least one to-be-tested charging pile includes at least a first charging pile 302 and a second charging pile 304; a predetermined load set 32, configured to provide loads for the at least one to-be-tested charging pile, where the predetermined load set includes a plurality of load modules; a main power supply 34, configured to supply power to the at least one to-be-tested charging pile; and a controller 36, connected to the at least one to-be-tested charging pile, the predetermined load set and the main power supply, and configured to obtain a test task set of a charging pile, where the test task set includes at least a first test task and a second test task; configure, based on the first test task, a first power supply and a first load required for executing the first test task by the charging pile, and configure, based on the second test task, a second power supply and a second load required for executing the second test task by the charging pile; control the first charging pile to execute the first test task based on the first power supply and the first load, and control the second charging pile to execute the second test task based on the second power supply and the second load; after the first charging pile completes the first test task and the second charging pile completes the second test task, control the first charging pile to execute the second test task based on the second power supply and the second load, and control the second charging pile to execute the first test task based on the first power supply and the first load, where the first power supply and the second power supply are configured based on the main power supply, and a sum of a power of the first power supply and a power of the second power supply is not higher than a total power of the main power supply; the first load and the second load are configured based on the predetermined load set, and a sum of a power of the first load and a power of the second load is not higher than a total power of the plurality of load modules in the predetermined load set.

In the embodiments of the present invention, a test task set of a charging pile is obtained, where the test task set includes: a first test task and a second test task; a first power supply and a first load required for executing the first test task by the charging pile are configured based on the first test task; a second power supply and a second load required for executing the second test task by the charging pile are configured based on the second test task; a first charging pile is controlled to execute to the first test task based on the first power supply and the first load, and a second charging pile is controlled to execute the second test task based on the second power supply and the second load; after the first charging pile completes the first test task and the second charging pile completes the second test task, the first charging pile is controlled to execute the second test task based on the second power supply and the second load, and the second charging pile is controlled to execute the first test task based on the first power supply and the first load, so that the first charging pile and the second charging pile can execute test tasks in a time division manner. That is, the second charging pile executes the second test task while the first charging pile executes the first test task, and after the first charging pile completes the first test task and the second charging pile also completes the second test task, the first test task and the second test task are exchanged, so that the first charging pile and the second charging pile can execute the same test task in different periods of time. Test tasks with relatively high powers and relatively high loads are arranged in the same period of time, so that a total power supply power required for the test and a total load power required for the test can be reduced when a plurality of charging piles are tested simultaneously. Therefore, with the limited total power supply power and the limited total load power, a plurality of charging piles can be tested simultaneously, thereby achieving the technical effect of improving the efficiency of batch testing for charging piles, and solving the technical problem of low efficiency of batch testing for charging piles.

In an optional embodiment, the plurality of load modules in the predetermined load set are connected through a switch array.

The present invention further provides a preferred embodiment, and the preferred embodiment provides an assembly line testing system for charging piles.

The assembly line testing system for charging piles is provided with a plurality of stations. If the power supply and load are configured based on the maximum test capability of each station, the total capacity reaches 1250 kW or higher, which results in an extremely high requirement on power supply and high equipment investment. The method of ordered control of test power supplies and load powers implements time division multiplexing of the power supplies and loads of the test stations in the system, and reduces the power supplies for the main test stations and the rated capacity configurations of the loads by 80%.

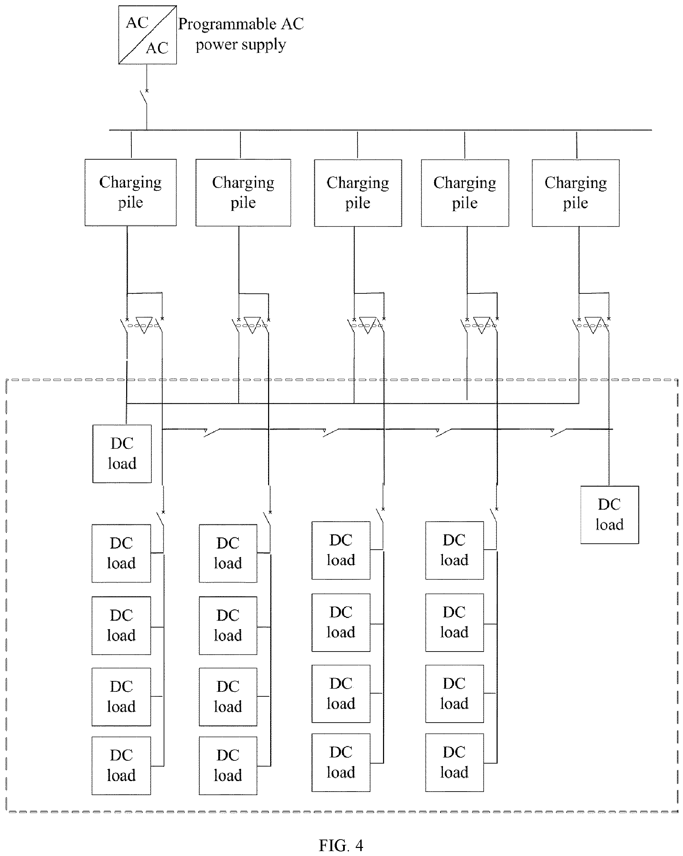

FIG. 4 is a schematic diagram of an assembly line testing system for charging piles according to an embodiment of the present invention. As shown in FIG. 4, a programmable AC power supply supplies electricity, a power of a single programmable AC power supply is 240 kW, and a plurality of power supplies are configured. The power supplies may be used in parallel, and are multiplexed in a time division manner.

As shown in FIG. 4, the assembly line testing system for charging piles adopts DC loads, which are configured according to parallel power levels. The DC loads include a plurality of low-power DC loads and a 240-Kw DC load. The DC loads are multiplexed in a time division manner, to effectively reduce the capacity of an incoming power line of a lab.

As shown in FIG. 4, the assembly line testing system for charging piles includes five automatic test stations, which are powered by one 240-kW programmable AC power supply. On the load side, each station is equipped with four 15-kW loads for carrying out a low-power test. The five stations multiplex sixteen 15-kW loads, with a total power of 240 kW, to carry out a high-power test.

As shown in FIG. 4, in the assembly line testing system for charging piles, the five charging piles are tested in parallel, including an electrical performance test, an interoperability test, a communication protocol consistency test, and a safety test (electrical related). In the electrical performance test, full-power tests are performed alternately, to effectively reduce the total incoming power of the lab.

The assembly line testing system for charging piles according to the present invention adopts the design of an adjustable power supply and time division multiplexing of a full-power load, and does not need a rated-capacity power supply or rated-capacity load. The power supply only needs to be configured with 1/8 of the total capacity, and the load only needs to be configured with 1/5 of the total capacity. In the high-power test, the programmable power supply and the high-power DC load are used, to perform the full-power test on a plurality of 240-kW DC charging piles at the same time. Under working conditions of low-power tests such as the interoperability test and the communication protocol consistency test, the DC resistive loads are used.

Optionally, the incoming capacity is configured based on the condition that one station operates with DC full capacity and one station operates with AC full capacity, and the incoming capacity is not lower than 300 kW.

In the technical solution of the present invention, the power supply and load powers are automatically distributed in a time division multiplexing manner, thereby effectively reducing the incoming capacity of the main power supply of the lab for testing charging piles in parallel. Moreover, the number of power supplies and the number of loads are reduced in the parallel test, thereby reducing the hardware equipment investment.

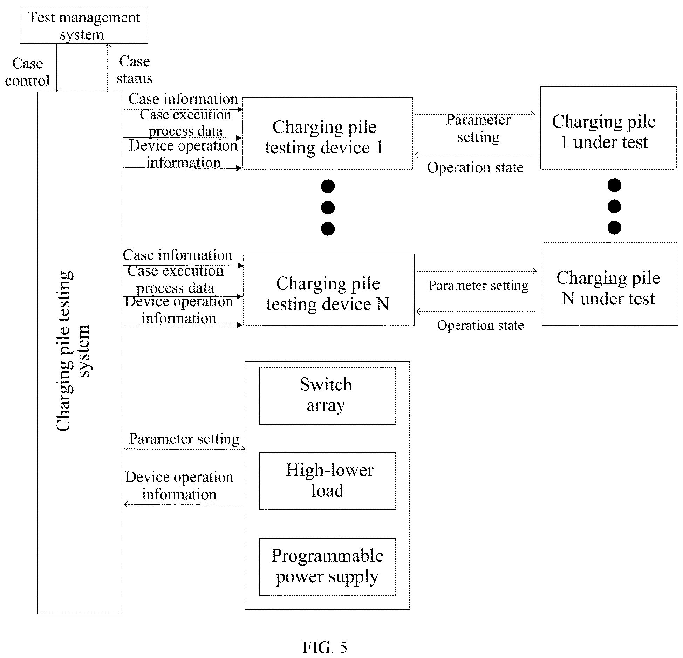

FIG. 5 is a schematic diagram of an assembly line test control part for charging piles according to an embodiment of the present invention. As shown in FIG. 5, the assembly line test control part includes: a test management system, a testing system for a charging pile, and an execution component (where the execution component includes a testing apparatus for a charging pile, a switch array, a high-power load, and a programmable power supply).

As shown in FIG. 5, the test management system is seamlessly connected to the testing system for a charging pile, issues a test case, and returns a case status, to implement test process management, including test task management, assembly line scheduling management, charging pile device management, test data management, and the like, thereby realizing effective operation and control of charging piles.

As shown in FIG. 5, the testing system for a charging pile is seamlessly connected to the testing apparatus for a charging pile, the switch array, the high-power load and the programmable power supply, and exchanges case information, case execution process data, and device operation information with the testing apparatus for a charging pile, to implement functions such as execution of a specific test item, result analysis, and test data uploading. Moreover, the testing system for a charging pile controls the programmable power supply, the high-power load, and the switch array, to set parameters and monitor operation information, thereby completing time division multiplexing in the test process.

As shown in FIG. 5, the testing apparatus for a charging pile is connected to charging piles under test, to implement execution of a single case and test data uploading.

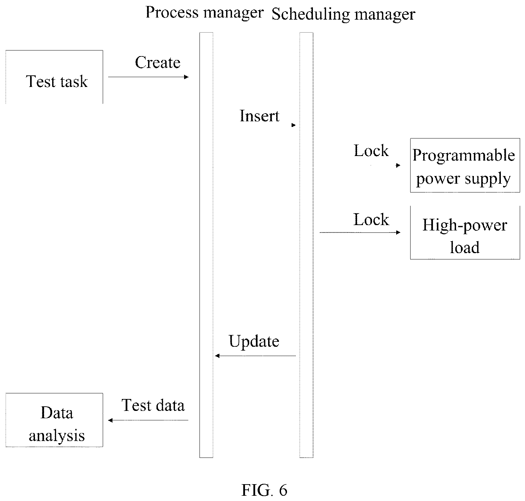

FIG. 6 is a schematic diagram of a test process of an assembly line for charging piles according to an embodiment of the present invention. As shown in FIG. 6, a plurality of charging piles are tested in parallel. A process manager adopts the scheme of parallel testing with automatic scheduling. It is unnecessary to sort test items of each charging pile, and all the test tasks are executed in parallel at the beginning of the test. After the programmable power supply and the high-power load are occupied, instead of waiting, the test program skips the current task to execute the next test, and then returns to the current test.

As shown in FIG. 6, the programmable power supply and the high-power load are used as multiplexed devices, the scheduling manager adopts a software lock to avoid repeated calls. A device is locked when being occupied, and is unlocked when being idle.

The sequence numbers of the foregoing embodiments of the present invention are merely for the purpose of description and do not represent advantages and disadvantages of the embodiments.

In the above embodiments, the description of the embodiments each has a focus, and for portions not described in detail in one embodiment, refer to the description of other embodiments.

In several embodiments provided in this application, it should be understood that the disclosed technical content may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In other respects, the inter-coupling or direct coupling or communication connection shown or discussed may be indirect coupling or communication connection through some interfaces, apparatuses, or units, or may be implemented in an electrical or other forms.

The units described as separate parts may or may not be physically separate. Parts displayed as units may or may not be physical units, which may be located in one position, or may be distributed on a plurality of network units. Some or all of the units may be selected according to actual needs to achieve the objectives of the solutions of the examples.

In addition, functional units in the examples of the present invention may be integrated into one processing unit, or each of the units may exist alone physically, or two or more units are integrated into one unit. The foregoing integrated unit can be implemented either in the form of hardware or in the form of software functional units.

The integrated unit, if implemented in the form of a software functional unit and sold or used as a stand-alone product, may be stored in a computer-readable storage medium. Based on such understanding, the technical solution of the present invention which is essentially or a part contributing to the prior art or a part of the technical solution may be embodied in the form of a software product. The computer software product is stored in a storage medium and includes a plurality of instructions for enabling a computer device (which may be a personal computer, a server, or a network device) to execute all or some steps of the method according to each embodiment of the present invention. The foregoing storage medium includes: a USB flash disk, a read-only memory (ROM), a random access memory (RAM), a mobile hard disk, a magnetic disk, an optical disc, or other media capable of storing program code.

## Claims

1. A testing method for a charging pile, wherein the method comprises:
obtaining a test task set of a charging pile, wherein the test task set comprises at least a first test task for instructing the charging pile to perform a test based on conditions of a first power supply and a first load, and a second test task for instructing the charging pile to perform a test based on conditions of a second power supply and a second load;
configuring the first power supply and the first load for a first charging pile in at least one to-be-tested charging pile and controlling the first charging pile to execute the first test task, and configuring the second power supply and the second load for a second charging pile in the at least one to-be-tested charging pile and controlling the second charging pile to execute the second test task; and
after the first charging pile completes the first test task and the second charging pile completes the second test task, configuring the second power supply and the second load for the first charging pile and controlling the first charging pile to execute the second test task, and configuring the first power supply and the first load for the second charging pile and controlling the second charging pile to execute the first test task;
the method further comprises:
monitoring all test tasks executed by a plurality of charging piles in the same period of time, and determining whether a total power supply power and a total load power required by all the test tasks in the same period of time exceed a total power supply power and a total load power that can be provided in a current environment; **characterized in that**
if in the same period of time, the first charging pile and the second charging pile execute the first test task simultaneously, and a total power supply power and a total load power required for executing the first test task by the first charging pile and the second charging pile simultaneously exceed the total power supply power and the total load power that can be provided in the current environment, selecting the second test task that requires a relatively low power supply power and load power from the test task set, and controlling the second charging pile executes the second test task while the first charging pile executes the first test task.

2. The method according to claim 1, **characterized in that** the configuring the first power supply for the first charging pile and configuring the second power supply for the second charging pile comprises:
controlling a main power supply to supply power to the first charging pile according to a power of the first power supply; and
controlling the main power supply to supply power to the second charging pile according to a power of the second power supply.

3. The method according to claim 1, **characterized in that** the configuring the first load for the first charging pile and configuring the second load for the second charging pile comprises:
selecting, according to a power of the first load, at least one load module from a predetermined load set and connecting the at least one load module in series to the first charging pile; and
selecting, according to a power of the second load, at least one load module from the predetermined load set and connecting the at least one load module in series to the second charging pile;
wherein the predetermined load set comprises a plurality of load modules, and the plurality of load modules are connected through a switch array.

4. A testing apparatus for a charging pile, wherein the apparatus comprises:
an obtaining unit (22), configured to obtain a test task set of a charging pile, wherein the test task set comprises, at least, a first test task for instructing the charging pile to perform a test based on conditions of a first power supply and a first load, and a second test task for instructing the charging pile to perform a test based on conditions of a second power supply and a second load;
a first test unit (24), configured to configure the first power supply and the first load for a first charging pile in at least one to-be-tested charging pile and control the first charging pile to execute the first test task, and configure the second power supply and the second load for a second charging pile in the at least one to-be-tested charging pile and control the second charging pile to execute the second test task; and
a second test unit (26), configured to: after the first charging pile completes the first test task and the second charging pile completes the second test task, configure the second power supply and the second load for the first charging pile and control the first charging pile to execute the second test task, and configure the first power supply and the first load for the second charging pile and control the second charging pile to execute the first test task;
monitor all test tasks executed by a plurality of charging piles in the same period of time, and determine whether a total power supply power and a total load power required by all the test tasks in the same period of time exceed a total power supply power and a total load power that can be provided in a current environment; **characterized in that** the apparatus is further configured to:
if in the same period of time, the first charging pile and the second charging pile execute the first test task simultaneously, and a total power supply power and a total load power required for executing the first test task by the first charging pile and the second charging pile simultaneously exceed the total power supply power and the total load power that can be provided in the current environment, select the second test task that requires a relatively low power supply power and load power from the test task set, and control the second charging pile executes the second test task while the first charging pile executes the first test task.

5. The apparatus according to claim 4, **characterized in that** the apparatus further comprises: a power supply control unit, wherein the power supply control unit comprises at least a first power supply control module and a second power supply control module,
the first power supply control module is configured to control a main power supply to supply power to the first charging pile according to a power of the first power supply; and
the second power supply control module is configured to control the main power supply to supply power to the second charging pile according to a power of the second power supply.

6. The apparatus according to claim 4, **characterized in that** the apparatus further comprises: a load control unit, wherein the load control unit comprises at least a first load control module and a second load control module,
the first load control module is configured to select, according to a power of the first load, at least one load module from a predetermined load set and connect the at least one load module in series to the first charging pile; and
the second load control module is configured to select, according to a power of the second load, at least one load module from the predetermined load set and connect the at least one load module in series to the second charging pile;
wherein the predetermined load set comprises a plurality of load modules, and the plurality of load modules are connected through a switch array.

7. A testing system for a charging pile, wherein the system comprises:
at least one to-be-tested charging pile (30), wherein the at least one to-be-tested charging pile (30) comprises at least a first charging pile (302) and a second charging pile (304);
a predetermined load set (32), configured to provide loads for the at least one to-be-tested charging pile, wherein the predetermined load set comprises plurality of load modules;
a main power supply (34), configured to supply power to the at least one to-be-tested charging pile; and
a testing apparatus according to claim 4 comprising a controller (36), connected to the at least one to-be-tested charging pile, the predetermined load set and the main power supply;
wherein the controller (36) is configured to monitor all test tasks executed by a plurality of charging piles in the same period of time, and determine whether a total power supply power and a total load power required by all the test tasks in the same period of time exceed a total power supply power and a total load power that can be provided in a current environment;
**characterized in that** the controller (36) is further configured to, if in the same period of time, the first charging pile and the second charging pile execute the first test task simultaneously, and a total power supply power and a total load power required for executing the first test task by the first charging pile and the second charging pile simultaneously exceed the total power supply power and the total load power that can be provided in the current environment, select the second test task that requires a relatively low power supply power and load power from the test task set, and control the second charging pile executes the second test task while the first charging pile executes the first test task;
wherein the first power supply and the second power supply are configured based on the main power supply, and a sum of a power of the first power supply and a power of the second power supply is not higher than a total power of the main power supply; the first load and the second load are configured based on the predetermined load set, and a sum of a power of the first load and a power of the second load is not higher than a total power of the plurality of load modules in the predetermined load set.

8. The system according to claim 7, **characterized in that** the plurality of load modules in the predetermined load set are connected through a switch array.

9. A storage medium, **characterized in that** the storage medium comprises a stored program, wherein the program, when being run, controls a device where the storage medium is located to perform the testing method for a charging pile according to any one of claims 1 to 3.

10. A processor, **characterized in that** the processor is configured to run a program, wherein the program, when being run, performs the testing method for a charging pile according to any one of claims 1 to 3.

## Patentansprüche

1. Prüfverfahren für eine Ladesäule, wobei das Verfahren umfasst:
Erhalten einer Prüfaufgabenmenge einer Ladesäule, wobei die Prüfaufgabenmenge mindestens eine erste Prüfaufgabe zum Anweisen der Ladesäule, eine Prüfung auf Grundlage von Zuständen einer ersten Leistungsversorgung und einer ersten Last durchzuführen, und eine zweite Prüfaufgabe zum Anweisen der Ladesäule umfasst, eine Prüfung auf Grundlage von Zuständen einer zweiten Leistungsversorgung und einer zweiten Last durchzuführen;
Konfigurieren der ersten Leistungsversorgung und der ersten Last für eine erste Ladesäule in mindestens einer zu prüfenden Ladesäule und Steuern der ersten Ladesäule, die erste Prüfaufgabe auszuführen, und Konfigurieren der zweiten Leistungsversorgung und der zweiten Last für eine zweite Ladesäule in der mindestens einen zu prüfenden Ladesäule und Steuern der zweiten Ladesäule, die zweite Prüfaufgabe auszuführen; und
nachdem die erste Ladesäule die erste Prüfaufgabe abgeschlossen hat und die zweite Ladesäule die zweite Prüfaufgabe abgeschlossen hat, Konfigurieren der zweiten Leistungsversorgung und der zweiten Last für die erste Ladesäule und Steuern der ersten Ladesäule, die zweite Prüfaufgabe auszuführen, und Konfigurieren der ersten Leistungsversorgung und der ersten Last für die zweite Ladesäule und Steuern der zweiten Ladesäule, die erste Prüfaufgabe durchzuführen;
wobei das Verfahren ferner umfasst: Überwachen aller Prüfaufgaben, die von einer Vielzahl von Ladesäulen in derselben Zeitspanne ausgeführt werden, und Ermitteln, ob eine Gesamtleistungsversorgungsleistung und eine Gesamtlastleistung, die für alle Prüfaufgaben in derselben Zeitspanne erforderlich ist, eine Gesamtleistungsversorgungsleistung und eine Gesamtlastleistung überschreiten, die in einer aktuellen Umgebung bereitgestellt werden können; **dadurch gekennzeichnet, dass** falls in derselben Zeitspanne die erste Ladesäule und die zweite Ladesäule die erste Prüfaufgabe gleichzeitig ausführen und eine Gesamtleistungsversorgungsleistung und eine Gesamtlastleistung, die zum gleichzeitigen Ausführen der ersten Prüfaufgabe durch die erste Ladesäule und der zweiten Ladesäule erforderlich ist, die Gesamtleistungsversorgungsleistung und die Gesamtlastleistung überschreiten, die in der aktuellen Umgebung bereitgestellt werden können, Auswählen der zweiten Prüfaufgabe, die eine relativ geringe Leistungsversorgungsleistung und Lastleistung erfordert, aus der Prüfaufgabenmenge und Steuern der zweiten Ladesäule, die zweite Prüfaufgabe auszuführen, während die erste Ladesäule die erste Prüfaufgabe ausführt.

2. Verfahren nach Anspruch 1, **dadurch gekennzeichnet, dass** das Konfigurieren der ersten Leistungsversorgung für die erste Ladesäule und das Konfigurieren der zweiten Leistungsversorgung für die zweite Ladesäule umfasst:
Steuern einer Hauptleistungsversorgung, um die erste Ladesäule in Übereinstimmung mit einer Leistung der ersten Leistungsversorgung mit Leistung zu versorgen; und
Steuern der Hauptleistungsversorgung, um die zweite Ladesäule in Übereinstimmung mit einer Leistung der zweiten Leistungsversorgung mit Leistung zu versorgen.

3. Verfahren nach Anspruch 1, **dadurch gekennzeichnet, dass** das Konfigurieren der ersten Last für die erste Ladesäule und das Konfigurieren der zweiten Last für die zweite Ladesäule umfasst:
Auswählen, in Übereinstimmung mit einer Leistung der ersten Last, mindestens eines Lastmoduls aus einer vorbestimmten Lastmenge und Verbinden des mindestens einen Lastmoduls in Reihe mit der ersten Ladesäule; und
Auswählen, in Übereinstimmung mit einer Leistung der zweiten Last, mindestens eines Lastmoduls aus der vorbestimmten Lastmenge und Verbinden des mindestens einen Lastmoduls in Reihe mit der zweiten Ladesäule;
wobei die vorbestimmte Lastmenge eine Vielzahl von Lastmodulen umfasst und die Vielzahl von Lastmodulen über eine Schaltungsanordnung verbunden ist.

4. Prüfvorrichtung für eine Ladesäule, wobei die Vorrichtung umfasst:
eine Bezugseinheit (22), die ausgelegt ist, eine Prüfaufgabenmenge einer Ladesäule zu erhalten, wobei die Prüfaufgabenmenge mindestens eine erste Prüfaufgabe zum Anweisen der Ladesäule, eine Prüfung auf Grundlage von Zuständen einer ersten Leistungsversorgung und einer ersten Last durchzuführen, und eine zweite Prüfaufgabe zum Anweisen der Ladesäule umfasst, eine Prüfung auf Grundlage von Zuständen einer zweiten Leistungsversorgung und einer zweiten Last durchzuführen;
eine erste Prüfeinheit (24), die ausgelegt ist, die erste Leistungsversorgung und die erste Last für eine erste Ladesäule in mindestens einer zu prüfenden Ladesäule zu konfigurieren und die erste Ladesäule zu steuern, die erste Prüfaufgabe auszuführen, und die zweite Leistungsversorgung und die zweite Last für eine zweite Ladesäule in der mindestens einen zu prüfenden Ladesäule zu konfigurieren und die zweite Ladesäule zu steuern, die zweite Prüfaufgabe auszuführen; und
eine zweite Prüfeinheit (26), die ausgelegt ist, nachdem die erste Ladesäule die erste Prüfaufgabe abgeschlossen hat und die zweite Ladesäule die zweite Prüfaufgabe abgeschlossen hat, die zweite Leistungsversorgung und die zweite Last für die erste Ladesäule zu konfigurieren und die erste Ladesäule zu steuern, die zweite Prüfaufgabe auszuführen, und die erste Leistungsversorgung und die erste Last für die zweite Ladesäule zu konfigurieren und die zweite Ladesäule zu steuern, die erste Prüfaufgabe durchzuführen;
alle Prüfaufgaben zu überwachen, die von einer Vielzahl von Ladesäulen in derselben Zeitspanne ausgeführt werden, und zu ermitteln, ob eine Gesamtleistungsversorgungsleistung und eine Gesamtlastleistung, die für alle Prüfaufgaben in derselben Zeitspanne erforderlich ist, eine Gesamtleistungsversorgungsleistung und eine Gesamtlastleistung überschreiten, die in einer aktuellen Umgebung bereitgestellt werden können; **dadurch gekennzeichnet, dass** die Vorrichtung ferner ausgelegt ist:
falls in derselben Zeitspanne die erste Ladesäule und die zweite Ladesäule die erste Prüfaufgabe gleichzeitig ausführen und eine Gesamtleistungsversorgungsleistung und eine Gesamtlastleistung, die zum gleichzeitigen Ausführen der ersten Prüfaufgabe durch die erste Ladesäule und der zweiten Ladesäule erforderlich ist, die Gesamtleistungsversorgungsleistung und die Gesamtlastleistung überschreiten, die in der aktuellen Umgebung bereitgestellt werden können, die zweite Prüfaufgabe, die eine relativ geringe Leistungsversorgungsleistung und Lastleistung erfordert, aus der Prüfaufgabenmenge auszuwählen und die zweite Ladesäule zu steuern, die zweite Prüfaufgabe auszuführen, während die erste Ladesäule die erste Prüfaufgabe ausführt.

5. Vorrichtung nach Anspruch 4, **dadurch gekennzeichnet, dass** die Vorrichtung ferner umfasst: eine Leistungsversorgungssteuereinheit, wobei die Leistungsversorgungssteuereinheit mindestens ein erstes Leistungsversorgungssteuermodul und ein zweites Leistungsversorgungssteuermodul umfasst,
das erste Leistungsversorgungssteuermodul ausgelegt ist, eine Hauptleistungsversorgung zu steuern, um die erste Ladesäule in Übereinstimmung mit einer Leistung der ersten Leistungsversorgung mit Leistung zu versorgen; und
das zweite Leistungsversorgungssteuermodul ausgelegt ist, die Hauptleistungsversorgung zu steuern, um die zweite Ladesäule in Übereinstimmung mit einer Leistung der zweiten Leistungsversorgung mit Leistung zu versorgen.

6. Vorrichtung nach Anspruch 4, **dadurch gekennzeichnet, dass** die Vorrichtung ferner umfasst: eine Laststeuereinheit, wobei die Laststeuereinheit mindestens ein erstes Laststeuermodul und ein zweites Laststeuermodul umfasst,
das erste Laststeuermodul ausgelegt ist, in Übereinstimmung mit einer Leistung der ersten Last, mindestens ein Lastmodul aus einer vorbestimmten Lastmenge auszuwählen und das mindestens eine Lastmodul in Reihe mit der ersten Ladesäule zu verbinden; und
das zweite Laststeuermodul ausgelegt ist, in Übereinstimmung mit einer Leistung der zweiten Last, mindestens ein Lastmodul aus der vorbestimmten Lastmenge auszuwählen und das mindestens eine Lastmodul in Reihe mit der zweiten Ladesäule zu verbinden;
wobei die vorbestimmte Lastmenge eine Vielzahl von Lastmodulen umfasst und die Vielzahl von Lastmodulen über eine Schaltungsanordnung verbunden ist.

7. Prüfsystem für eine Ladesäule, wobei das System umfasst:
mindestens eine zu prüfende Ladesäule (30), wobei die mindestens eine zu prüfende Ladesäule (30) mindestens eine erste Ladesäule (302) und eine zweite Ladesäule (304) umfasst;
eine vorbestimmte Lastmenge (32), die ausgelegt ist, Lasten für die mindestens eine zu prüfende Ladesäule bereitzustellen, wobei die vorbestimmte Lastmenge eine Vielzahl von Lastmodulen umfasst;
eine Hauptleistungsversorgung (34), die ausgelegt ist, die mindestens eine zu prüfende Ladesäule mit Leistung zu versorgen; und
eine Prüfvorrichtung nach Anspruch 4, umfassend eine Steuerung (36), die mit der mindestens einen zu prüfenden Ladesäule, der vorbestimmten Lastmenge und der Hauptleistungsversorgung verbunden ist;
wobei die Steuerung (36) ausgelegt ist, alle Prüfaufgaben zu überwachen, die von einer Vielzahl von Ladesäulen in derselben Zeitspanne ausgeführt werden, und zu ermitteln, ob eine Gesamtleistungsversorgungsleistung und eine Gesamtlastleistung, die von allen Prüfaufgaben in derselben Zeitspanne gefordert werden, eine Gesamtleistungsversorgungsleistung und eine Gesamtlastleistung überschreitet, die in einer aktuellen Umgebung bereitgestellt werden kann;
**dadurch gekennzeichnet, dass** die Steuerung (36) ferner ausgelegt ist, falls in derselben Zeitspanne die erste Ladesäule und die zweite Ladesäule die erste Prüfaufgabe gleichzeitig ausführen und eine Gesamtleistungsversorgungsleistung und eine Gesamtlastleistung, die zum gleichzeitigen Ausführen der ersten Prüfaufgabe durch die erste Ladesäule und der zweiten Ladesäule erforderlich ist, die Gesamtleistungsversorgungsleistung und die Gesamtlastleistung überschreiten, die in der aktuellen Umgebung bereitgestellt werden können, die zweite Prüfaufgabe, die eine relativ geringe Leistungsversorgungsleistung und Lastleistung erfordert, aus der Prüfaufgabenmenge auszuwählen und die zweite Ladesäule zu steuern, die zweite Prüfaufgabe auszuführen, während die erste Ladesäule die erste Prüfaufgabe ausführt;
wobei die erste Leistungsversorgung und die zweite Leistungsversorgung auf Grundlage der Hauptleistungsversorgung konfiguriert sind und eine Summe einer Leistung der ersten Leistungsversorgung und einer Leistung der zweiten Leistungsversorgung nicht höher als eine Gesamtleistung der Hauptleistungsversorgung ist; die erste Last und die zweite Last auf Grundlage der vorbestimmten Lastmenge konfiguriert sind und eine Summe einer Leistung der ersten Last und einer Leistung der zweiten Last nicht höher als eine Gesamtleistung der Vielzahl von Lastmodulen in der vorbestimmten Lastmenge ist.

8. System nach Anspruch 7, **dadurch gekennzeichnet, dass** die Vielzahl von Lastmodulen in der vorbestimmten Lastmenge über eine Schaltungsanordnung verbunden ist.

9. Speichermedium, **dadurch gekennzeichnet, dass** das Speichermedium ein gespeichertes Programm umfasst, wobei das Programm, wenn es ausgeführt wird, eine Einrichtung steuert, auf der sich das Speichermedium befindet, um das Prüfverfahren für eine Ladesäule nach einem der Ansprüche 1 bis 3 durchzuführen.

10. Prozessor, **dadurch gekennzeichnet, dass** der Prozessor ausgelegt ist, ein Programm auszuführen, wobei das Programm, wenn es ausgeführt wird, das Prüfverfahren für eine Ladesäule nach einem der Ansprüche 1 bis 3 durchführt.

## Revendications

1. Procédé de test pour une borne de recharge, dans lequel le procédé comprend :
obtenir un ensemble de tâches de test d'une borne de recharge, dans lequel l'ensemble de tâches de test comprend au moins une première tâche de test pour instruire la borne de recharge de réaliser un test basé sur des conditions d'une première alimentation électrique et d'une première charge, et une seconde tâche de test pour instruire la borne de recharge de réaliser un test basé sur des conditions d'une seconde alimentation électrique et d'une seconde charge ;
configurer la première alimentation électrique et la première charge pour une première borne de recharge dans au moins une borne de recharge devant être testée et commander la première borne de recharge d'exécuter la première tâche de test, et configurer la seconde alimentation électrique et la seconde charge pour une seconde borne de recharge dans l'au moins une borne de recharge devant être testée et commander la seconde borne de recharge d'exécuter la seconde tâche de test ; et
après que la première borne de recharge achève la première tâche de test et la seconde borne de recharge achève la seconde tâche de test, configurer la seconde alimentation électrique et la seconde charge pour la première borne de recharge et commander la première borne de recharge d'exécuter la seconde tâche de test, et configurer la première alimentation électrique et la première charge pour la seconde borne de recharge et commander la seconde borne de recharge d'exécuter la première tâche de test ;
le procédé comprend en outre :
surveiller l'ensemble des tâches de test exécutées par une pluralité de bornes de recharge dans la même période de temps, et déterminer si une puissance d'alimentation électrique totale et une puissance de charge totale requises par l'ensemble des tâches de test dans la même période de temps dépassent une puissance d'alimentation électrique totale et une puissance de charge totale qui peuvent être fournies dans un environnement actuel ; **caractérisé en ce que** si dans la même période de temps, la première borne de recharge et la seconde borne de recharge exécutent la première tâche de test simultanément, et une puissance d'alimentation électrique totale et une puissance de charge totale requises pour exécuter la première tâche de test par la première borne de recharge et la seconde borne de recharge simultanément dépassent la puissance d'alimentation électrique totale et la puissance de charge totale qui peuvent être fournies dans l'environnement actuel, sélectionner la seconde tâche de test qui requiert une puissance d'alimentation électrique et puissance de charge relativement basses parmi l'ensemble de tâches de test, et commander la seconde borne de recharge d'exécuter la seconde tâche de test tandis que la première borne de recharge exécute la première tâche de test.

2. Procédé selon la revendication 1, **caractérisé en ce que** la configuration de la première alimentation électrique pour la première borne de recharge et la configuration de la seconde alimentation électrique pour la seconde borne de recharge comprennent :
commander une alimentation électrique principale de fournir de la puissance à la première borne de recharge en fonction d'une puissance de la première alimentation électrique ; et
commander l'alimentation électrique principale de fournir de la puissance à la seconde borne de recharge en fonction d'une puissance de la seconde alimentation électrique.

3. Procédé selon la revendication 1, **caractérisé en ce que** la configuration de la première charge pour la première borne de recharge et la configuration de la seconde charge pour la seconde borne de recharge comprennent :
sélectionner, en fonction d'une puissance de la première charge, au moins un module de charge parmi un ensemble de charges prédéterminé et connecter l'au moins un module de charge en série à la première borne de recharge ; et
sélectionner, en fonction d'une puissance de la seconde charge, au moins un module de charge parmi l'ensemble de charges prédéterminé et connecter l'au moins un module de charge en série à la seconde borne de recharge ;
dans lequel l'ensemble de charges prédéterminé comprend une pluralité de modules de charge, et la pluralité de modules de charge sont connectés par une matrice de commutateurs.

4. Appareil de test pour une borne de recharge, dans lequel l'appareil comprend :
un module d'obtention (22), configuré pour obtenir un ensemble de tâches de test d'une borne de recharge, dans lequel l'ensemble de tâches de test comprend au moins une première tâche de test pour instruire la borne de recharge de réaliser un test basé sur des conditions d'une première alimentation électrique et
d'une première charge, et une seconde tâche de test pour instruire la borne de recharge de réaliser un test basé sur des conditions d'une seconde alimentation électrique et d'une seconde charge ;
une première unité de test (24), configurée pour configurer la première alimentation électrique et la première charge pour une première borne de recharge dans au moins une borne de recharge devant être testée et commander la première borne de recharge d'exécuter la première tâche de test, et configurer la seconde alimentation électrique et la seconde charge pour une seconde borne de recharge dans l'au moins une borne de recharge devant être testée et commander la seconde borne de recharge d'exécuter la seconde tâche de test ; et
une seconde unité de test (26), configurée pour : après que la première borne de recharge achève la première tâche de test et la seconde borne de recharge achève la seconde tâche de test, configurer la seconde alimentation électrique et la seconde charge pour la première borne de recharge et commander la première borne de recharge d'exécuter la seconde tâche de test, et configurer la première alimentation électrique et la première charge pour la seconde borne de recharge et commander la seconde borne de recharge d'exécuter la première tâche de test ;
surveiller l'ensemble des tâches de test exécutées par une pluralité de bornes de recharge dans la même période de temps, et déterminer si une puissance d'alimentation électrique totale et une puissance de charge totale requises par l'ensemble des tâches de test dans la même période de temps dépassent une puissance d'alimentation électrique totale et une puissance de charge totale qui peuvent être fournies dans un environnement actuel ; **caractérisé en ce que** l'appareil est en outre configuré pour :
si dans la même période de temps, la première borne de recharge et la seconde borne de recharge exécutent la première tâche de test simultanément, et une puissance d'alimentation électrique totale et une puissance de charge totale requises pour exécuter la première tâche de test par la première borne de recharge et la seconde borne de recharge simultanément dépassent la puissance d'alimentation électrique totale et la puissance de charge totale qui peuvent être fournies dans l'environnement actuel, sélectionner la seconde tâche de test qui requiert une puissance d'alimentation électrique et puissance de charge relativement basses parmi l'ensemble de tâches de test, et commander la seconde borne de recharge d'exécuter la seconde tâche de test tandis que la première borne de recharge exécute la première tâche de test.

5. Appareil selon la revendication 4, **caractérisé en ce que** l'appareil comprend en outre : une unité de commande d'alimentation électrique, dans lequel l'unité de commande d'alimentation électrique comprend au moins un premier module de commande d'alimentation électrique et un second module de commande d'alimentation électrique,
le premier module de commande d'alimentation électrique est configuré pour commander une alimentation électrique principale de fournir de la puissance à la première borne de recharge en fonction d'une puissance de la première alimentation électrique ; et
le second module de commande d'alimentation électrique est configuré pour commander l'alimentation électrique principale de fournir de la puissance à la seconde borne de recharge en fonction d'une puissance de la seconde alimentation électrique.

6. Appareil selon la revendication 4, **caractérisé en ce que** l'appareil comprend en outre : une unité de commande de charge, dans lequel l'unité de commande de charge comprend au moins un premier module de commande de charge et un second module de commande de charge,
le premier module de commande de charge est configuré pour sélectionner, en fonction d'une puissance de la première charge, au moins un module de charge parmi un ensemble de charges prédéterminé et connecter l'au moins un module de charge en série à la première borne de recharge ; et
le second module de commande de charge est configuré pour sélectionner, en fonction d'une puissance de la seconde charge, au moins un module de charge parmi l'ensemble de charges prédéterminé et connecter l'au moins un module de charge en série à la seconde borne de recharge ;
dans lequel l'ensemble de charges prédéterminé comprend une pluralité de modules de charge, et la pluralité de modules de charge sont connectés par une matrice de commutateurs.

7. Système de test pour une borne de recharge, dans lequel le système comprend :
au moins une borne de recharge devant être testée (30), dans lequel l'au moins une borne de recharge devant être testée (30) comprend au moins une première borne de recharge (302) et une seconde borne de recharge (304) ;
un ensemble de charges prédéterminé (32), configuré pour fournir des charges pour l'au moins une borne de recharge devant être testée, dans lequel l'ensemble de charges prédéterminé comprend une pluralité de modules de charge ;
une alimentation électrique principale (34), configurée pour fournir de la puissance à l'au moins une borne de recharge devant être testée ; et
un appareil de test selon la revendication 4 comprenant un contrôleur (36), connecté à l'au moins une borne de recharge devant être testée, l'ensemble de charges prédéterminé et l'alimentation électrique principale ;
dans lequel le contrôleur (36) est configuré pour surveiller l'ensemble des tâches de test exécutées par une pluralité de bornes de recharge dans la même période de temps, et déterminer si une puissance d'alimentation électrique totale et une puissance de charge totale requises par l'ensemble des tâches de test dans la même période de temps dépassent une puissance d'alimentation électrique totale et une puissance de charge totale qui peuvent être fournies dans un environnement actuel ;
**caractérisé en ce que** le contrôleur (36) est en outre configuré pour, si dans la même période de temps, la première borne de recharge et la seconde borne de recharge exécutent la première tâche de test simultanément, et une puissance d'alimentation électrique totale et une puissance de charge totale requises pour exécuter la première tâche de test par la première borne de recharge et la seconde borne de recharge simultanément dépassent la puissance d'alimentation électrique totale et la puissance de charge totale qui peuvent être fournies dans l'environnement actuel, sélectionner la seconde tâche de test qui requiert une puissance d'alimentation électrique et puissance de charge relativement basses parmi l'ensemble de tâches de test, et commander la seconde borne de recharge d'exécuter la seconde tâche de test tandis que la première borne de recharge exécute la première tâche de test ;
dans lequel la première alimentation électrique et la seconde alimentation électrique sont configurées en fonction de l'alimentation électrique principale, et une somme d'une puissance de la première alimentation électrique et d'une puissance de la seconde alimentation électrique n'est pas supérieure à une puissance totale de l'alimentation électrique principale ; la première charge et la seconde charge sont configurées en fonction de l'ensemble de charges prédéterminé, et une somme d'une puissance de la première charge et d'une puissance de la seconde charge n'est pas supérieure à une puissance totale de la pluralité de modules de charge dans l'ensemble de charges prédéterminé.

8. Système selon la revendication 7, **caractérisé en ce que** la pluralité de modules de charge dans l'ensemble de charges prédéterminé sont connectés par une matrice de commutateurs.

9. Support de stockage, **caractérisé en ce que** le support de stockage comprend un programme stocké, dans lequel le programme, lors de son exécution, commande un dispositif où le support de stockage est situé de réaliser le procédé de test pour une borne de recharge selon l'une quelconque des revendications 1 à 3.

10. Processeur, **caractérisé en ce que** le processeur est configuré pour exécuter un programme, dans lequel le programme, lors de son exécution, réalise le procédé de test pour une borne de recharge selon l'une quelconque des revendications 1 à 3.
